# EUROPEAN PATENT SPECIFICATION

(11) **EP 4 213 397 B1**
(45) Date of publication and mention of the grant of the patent: **03.12.2025**
(21) Application number: 22151519.0
(22) Date of filing: 14.01.2022
(51) Int. Cl.: H04B 1/10, G01R 23/163, G01R 29/08

(54) **SYSTEM AND METHOD FOR FILTERING RF OR MW SIGNALS**
SYSTEM UND VERFAHREN ZUR FILTERUNG VON HF- ODER MW-SIGNALEN
SYSTÈME ET PROCÉDÉ DE FILTRAGE DE SIGNAUX RF OU MW

(43) Date of publication of application: 19.07.2023
(73) Proprietor: Rohde & Schwarz GmbH & Co. KG, 81671 München (DE)
(72) Inventor: Ruster, Thomas, 81543 Munich (DE); Renardy, Paul, 81927 Munich (DE)
(74) Representative: Novagraaf Group

(56) References cited:
- EP-A1- 3 809 145
- JP-A- 2017 129 741
- US-A1- 2014 079 107
- US-A1- 2017 149 464

## Description

### TECHNICAL FIELD OF THE INVENTION

The invention generally relates to spectrum monitoring and signal analysis of weak radio frequency (RF) or microwave (MW) signals in the presence of strong interfering signals. In particular, the invention relates to a system and a method for filtering an RF or MW signal.

### BACKGROUND OF THE INVENTION

Conventional real-time spectrum analysis devices often comprise attenuators, which are inserted into a signal path of the device to prevent overloading. However, these attenuators can affect the signal to be analyzed, thereby significantly reducing a signal-to-noise ratio of the measurement.

In particular, the entire output of the attenuator can become invalid when the signal to be analyzed is relatively weak and there is a strong interference signal at a single frequency component. Hence, it would be desirable to selectively remove such interference signals from a signal to be analyzed.

Thus, it is an objective to provide an improved system and an improved method for filtering an RF or a MW signal, which avoid the above-mentioned disadvantages. In particular, it is an objective to analyze a weak RF or MW signal in the presence of a strong interfering signal.

In this context, US 2014/0079107 A1, JP 2017-129741 A, and US 2017/0149464 A1 disclose related prior art.

### SUMMARY OF THE INVENTION

The object of the present invention is achieved by the solution provided in the enclosed independent claims. Advantageous implementations of the present invention are further defined in the dependent claims.

According to a first aspect, the invention relates to a system for filtering a radio frequency (RF) or microwave (MW) signal comprising at least one frequency band. The system comprises at least one quantum sensor which is arranged to receive the RF or MW signal.

The quantum sensor may be e.g. based on (doped) solid state materials, one or more gases or atoms.

The quantum sensor is configured to measure a spectrum of the RF or MW signal in a determined frequency range; a processing unit which is configured to analyze said spectrum to detect if a signal strength of one or more frequency bands of the RF or MW signal within the frequency range exceed a predefined threshold; and an adjustable filter unit which is arranged to receive and to filter the RF or MW signal; wherein the processing unit is configured to adapt a filter function of the adjustable filter unit based on the analysis of the spectrum, wherein the at least one quantum sensor comprises a reach-through output being directly connected to the adjustable filter unit.

This achieves the advantage that the system can attenuate frequency components of an RF or MW signal with strong interfering signals, while other frequency ranges of the signal remain unaffected. In other words, the system can selectively remove an interference signal which occurs within a specific frequency range of an RF or MW signal.

In particular, the spectrum represents a signal strength, e.g. in terms of intensity or power, of the signal as a function of frequency or wavelength.

The threshold can be different for each frequency band, i.e. the threshold can be frequency dependent.

The processing unit can be a microprocessor.

The quantum sensor, the processing unit and/or the filter unit 107 can be arranged in the same housing, or can be arranged separately from each other and only be electrically connected.

For example, the RF or MW signal is a radar signal which can comprise strong interference signals in certain frequency ranges. The signal can further be a signal according to a 3G, 4G, 5G or 6G standard. The RF signal can be in a kHz, MHz or GHz range.

The determined frequency range can be the measurement range of the quantum sensor, i.e. a frequency range in which the quantum sensor is capable to measure a spectrum.

The filter unit can comprise one or more filters, in particular band-pass filters.

The filter function can refer to the transfer function of the filter unit. In particular, the filter function defines a frequency dependent transmission characteristic of the filter unit. The filter function can depend on at least one filter coefficient.

In an embodiment, the processing unit is configured to adapt the filter function of the adjustable filter unit to filter out or attenuate at least one frequency band of the RF or MW signal that exceeds the predefined threshold.

In particular, the frequency band exceeding the threshold means the signal strength of the signal within the frequency band exceeds the threshold.

In an embodiment, the processing unit is configured to control at least one filter coefficient of the adjustable filter unit to adapt the filter function of the adjustable filter unit. This achieves the advantage that the filter unit can be adapted efficiently to remove only specific frequency bands from the signal, while leaving other frequency bands unaffected.

In an embodiment, the filter unit comprises a plurality of filters forming a filter bank.

In an embodiment, the filter unit is configured to divide the RF or MW signal into more than one separate signals. This achieves the advantage that the separate signals can subsequently be forwarded and/or analyzed separately.

In an embodiment, the quantum sensor unit contains an output which can be further analyzed by other devices (depending on the waveguide/antenna configuration in the sensor, the RF/MW signal is not attenuated much).

In an embodiment, the system comprises at least one analyzing instrument which is arranged to receive the filtered RF or MW signal from the filter unit. This achieves the advantage that weak signal components of the RF or MW signal can be analyzed efficiently without being influenced by strong interfering signals.

In an embodiment, the at least one analyzing instrument comprises an analog-to-digital converter (ADC) configured to digitalize the filtered RF or MW signal.

In particular, the at least one analyzing instrument can be configured to further attenuate and subsequently analyze the filtered signal.

In an embodiment, the processing unit is configured to calculate the threshold based on a result function, wherein the results function is configured to maximize a dynamic range of the at least one analyzing instrument while preventing an overload of the analyzing instrument. This achieves the advantage that weak signal components of the RF or MW signal can be analyzed efficiently without being influenced by strong interfering signals.

In an embodiment, the threshold is a user defined threshold. This achieves the advantage that a user can adjust the threshold based on a dynamic range of an analyzing instrument receiving the filtered signal.

In an embodiment, the quantum sensor is a gas based quantum sensor comprises: an enclosure filled with a gas containing atoms of at least one known type, such as e.g. particular Rydberg atoms, wherein the enclosure is arranged such that the RF or MW signal acts on the atoms of the gas; at least one light source configured to emit light capable of exciting the atoms of the gas; a sensor configured to capture light emitted by and/or passed through the gas; and an electrical field source and/or a magnetic field source configured to establish a predefined electrical field and/or magnetic field acting on the atoms of the gas, such that the light captured by the sensor reflects a response of the atoms of the gas on the electrical and/or magnetic field, the light from the at least one light source and the RF or MW signal. This achieves the advantage that the spectrum of the filter can be measured with high precision. In particular, the quantum sensor can detect signal components in the spectrum without being influenced by interfering signals at other frequencies.

The electrical and/or magnetic field can be inhomogeneous, i.e. in different areas of the gas enclosure are different values of the electrical and/or magnetic field. The inhomogeneous electric and/or magnetic field can be static.

In particular, the atoms of the gas optionally can be excited into a Rydberg state.

The sensor can be an optical sensor and can generate a sensor output based on the captured light. The sensor can be a camera.

In an embodiment, the sensor is configured to capture an at least two dimensional image of the light emitted by and/or passed through the gas; wherein the gas based sensor comprises a spectrum analysis module configured to calculate the spectrum of the RF or MW signal on the basis of the image.

The adjustable filter unit may be arranged to receive the RF or MW signal from a pass-through output of the at least one quantum sensor.

The at least one quantum sensor and the adjustable filter unit may be arranged to receive respective split portions of the RF or MW signal.

According to a second aspect, the invention relates to a system for filtering a radio frequency (RF) or microwave (MW) signal comprising at least one frequency band. The system comprises at least multi-channel spectrum analysis device which is arranged to receive the RF or MW signal, wherein the multi-channel spectrum analysis device is configured to measure a spectrum of the RF or MW signal in a determined frequency range; a processing unit which is configured to analyze said spectrum to detect if a signal strength of one or more frequency bands of the RF or MW signal within the frequency range exceed a predefined threshold; an adjustable filter unit which is arranged to receive and to filter the RF or MW signal; wherein the processing unit is configured to adapt a filter function of the adjustable filter unit based on the analysis of the spectrum.

Besides the use of a multi-channel spectrum analysis device instead of a gas based sensor, the system according to the second aspect of the invention can be essentially identical to the system according to the first aspect of the invention. Thus, the above description with regard to the system according to the first aspect of the invention is correspondingly valid for the system according to the second aspect of the invention.

According to a third aspect, the invention relates to a method for filtering a radio frequency (RF) or microwave (MW) signal comprising at least one frequency band, the method comprising:
- feeding the RF or MW signal to at least one quantum sensor;
- measuring, with the quantum sensor, a spectrum of the RF or MW signal in a determined frequency range;
- analyzing said spectrum to detect if a signal strength of one or more frequency bands of the RF or MW signal in the frequency range exceed a predefined threshold;
- adapting a filter function of an adjustable filter unit based on the analysis of the spectrum; and
- filtering the RF or MW signal with the adjustable filter unit.

In an embodiment, the step of filtering the RF or MW signal comprises filtering out or attenuating at least one frequency band of the RF or MW signal that exceeds the predefined threshold.

In an embodiment, the filter function of the adjustable filter unit is adapted by controlling at least one filter coefficient of the adjustable filter unit.

The above description with regard to the system according to the first aspect of the present invention is correspondingly valid for the method according to the third aspect of the invention.

### BRIEF DESCRIPTION OF THE DRAWINGS

The invention will be explained in the followings together with the figures.
- Figs. 1A-D: show systems for filtering an RF or MW signal according to embodiments;
- Fig. 2: shows a system for filtering an RF or MW signal according to an embodiment;
- Fig. 3: shows a schematic diagram of a gas based quantum sensor according to an embodiment;
- Fig. 4: shows an alternative system for filtering an RF or MW signal according to an embodiment; and
- Fig. 5: shows a method for filtering an RF or MW signal according to an embodiment.

### DETAILED DESCRIPTION OF THE PREFERRED EMBODIMENTS

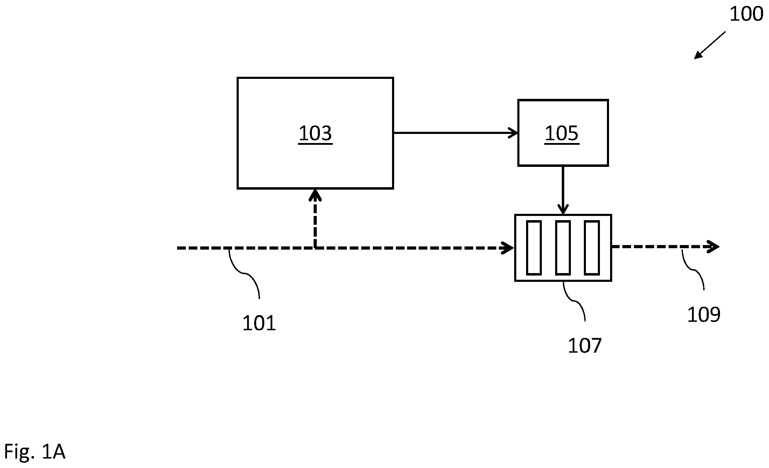

Fig. 1A shows a system 100 for filtering an RF or MW signal 101 according to an embodiment. Thereby, the RF or MW signal 101 comprises at least one frequency band.

The system 100 comprises at least one quantum sensor 103 which is arranged to receive the RF or MW signal 101. The quantum sensor may be e.g. based on (doped) solid state materials, one or more gases or atoms.

Note that "at least one quantum sensor" also comprise one or an ensemble of quantum sensors, and components to control it/them.

The quantum sensor 103 is configured to measure a spectrum of the RF or MW signal 101 in a determined frequency range, and a processing unit 105 which is configured to analyze said spectrum to detect if a signal strength of one or more frequency bands of the RF or MW signal 101 within the frequency range exceed a threshold. The system 100 further comprises an adjustable filter unit 107 which is arranged to receive the RF or MW signal 101 and to filter the RF or MW signal 101, wherein the processing unit 105 is configured to adapt a filter function of the adjustable filter unit 107 based on said analysis of the spectrum.

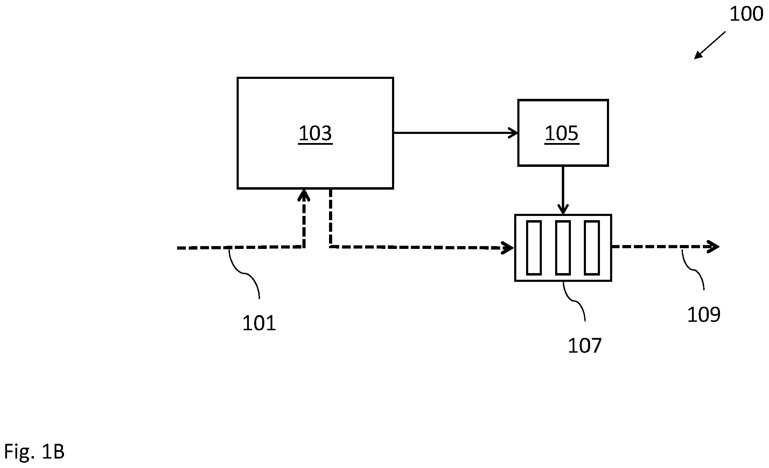

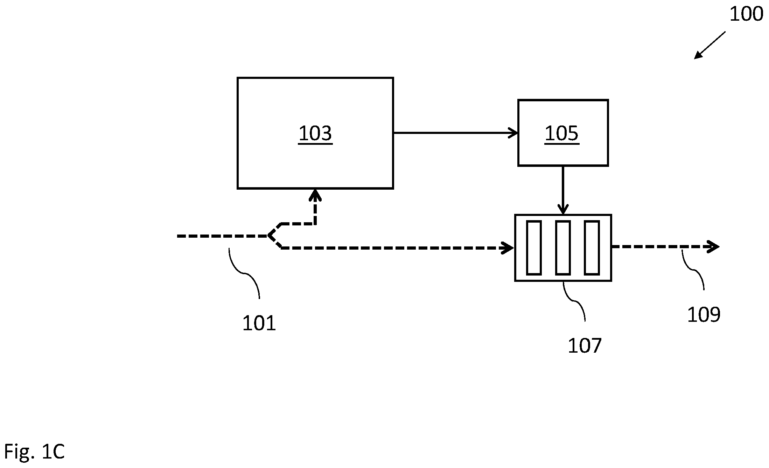

There are e.g. the following options of directing the RF or MW signal 101 to the filter unit 107:
1) The quantum sensor 103 may contain a pass-through output to re-use the input signal. This pass-through output is then fed to the filter unit & analysis device (see Fig. 1B).
2) The input signal is divided into two paths. One path is fed to the quantum sensor 103, and one path to the filter unit 107 which may comprise a filter bank and an analysis device (see Fig. 1C).

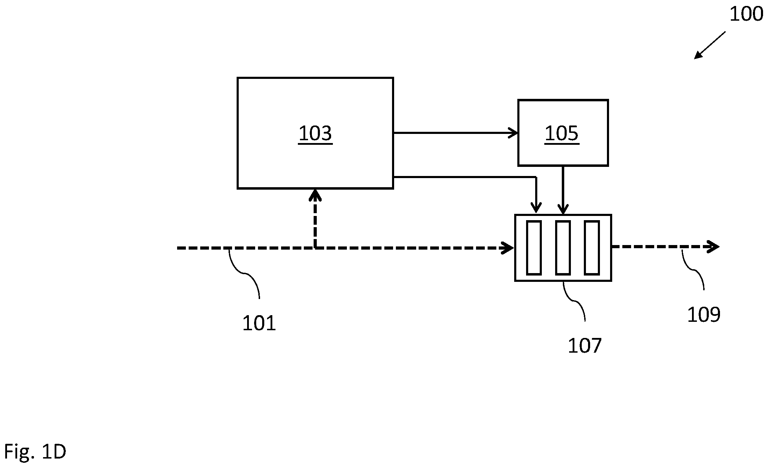

The quantum sensor unit 103 further contains a reach-through output, and this reach-through output is directly fed to the filter unit 107 (see Fig. 1D).

The processing unit 105 can be a microprocessor. The processing unit can be communicatively connected to the quantum sensor 103, to receive the spectrum, and to the filter unit 107 to control the filter unit 107 to adapt its filter function.

In particular, the processing unit 105 is configured to adapt the filter function of the adjustable filter unit 107 to filter out and/or attenuate at least one frequency band of the RF or MW signal that exceeds the threshold. In this way, strong interference signals in certain frequency bands can efficiently be removed from the signal 101. For instance, an interference signal is defined by a respective power in a frequency band exceeding a threshold.

The filter unit 107 can be configured to filter the RF or MW signal 101 based on the adapted filter function. The filter unit 107 can comprise one or more filters.

In particular, the one or more filters of the filter unit 107 can form a filter bank. For example, the filter bank can comprise an array of band-pass filters and can be configured to divide the RF or MW signal into multiple separate signals. For instance, each of the multiple signals can carry a frequency band of the RF or MW signal.

After passing through the filter unit 107 the RF or MW signal is converted to a filtered RF or MW signal 109. For example, in the filtered RF or MW signal certain frequency bands of the signal 101 which exceed the threshold value are attenuated.

The threshold can be predefined by a user or by the processing unit 105. The system can comprise a user interface (not shown) which allows a user to enter the threshold. The threshold can further be frequency dependent, i.e. the threshold can differ for each frequency band. Such a frequency dependent threshold can be defined by a threshold function.

The system 100 can further comprise a signal-splitter or RF-divider (or similar component) which is configured to split the RF or MW signal in two, preferably identical, parts, wherein one part is fed to the quantum sensor 103 and the other part is fed to the filter unit 107 for filtering.

The RF or MW signal 101 can be fed to the quantum sensor 103 and the filter unit 107 via a wired connection.

In particular, the quantum sensor 103 and/or the processing unit 105 can separate the RF or MW signal 101 into different frequency bands (analysis channels) and can optimize the filter coefficients of the filter unit 107 accordingly. The quantum sensor 103 can analyzes strong signal components while conventional sensors analyze weak signal components.

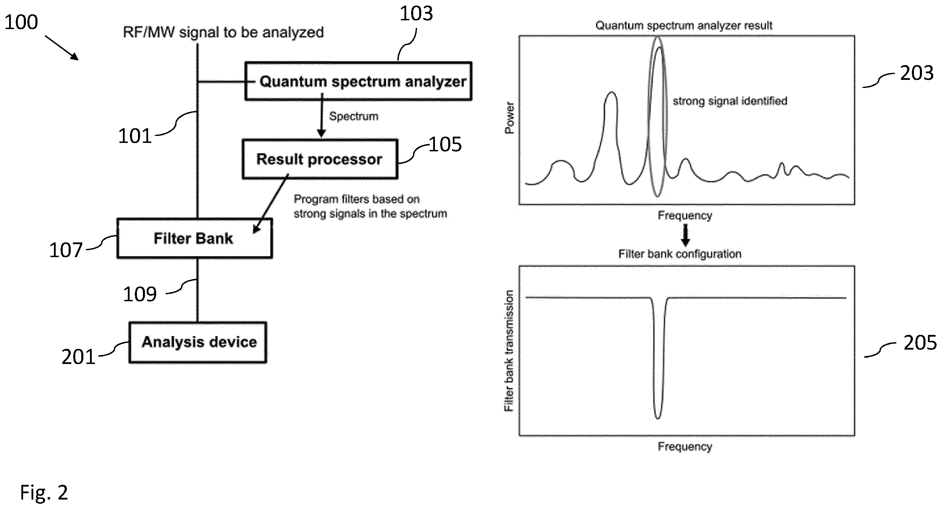

Fig. 2 shows the system 100 for filtering the RF or MW signal 101 according to an embodiment.

The system 100 shown on the left side of Fig. 2 further comprises an analyzing instrument 201 which is arranged to receive the filtered RF or MW signal 109 from the filter unit 107.

The system 100 can work as follows: the RF or MW signal 101 to be analyzed is connected to the quantum sensor 103, which can form a quantum spectrum analyzer. The measured spectrum of the quantum spectrum analyzer 103 is then processed by the processing unit, which can be a "result processor" (e.g. a software running on a PC) and which identifies frequency ranges in the RF or MW signal 101 with strong interference signals. The signal 101 is then filtered by the filter unit 107, e.g. a filter bank, which is programmed by the result processor 105 to attenuate the signal in the previously identified frequency ranges. The output of the filter bank 107 can then be further analyzed by the analyzing instrument 201 which can comprise an ADC for digitalizing the filtered signal 109.

The analyzing instrument 201 can be configured to further analyze the filtered signal 109. For instance, the analyzing instrument is a conventional signal or spectrum analyzer, e.g. for mobile network testing.

The processing unit 105 can be configured to calculate the threshold based on a result function. The results function can be determined by the processing unit 105 based on the measured spectrum of the signal 107 and/or on properties of the analyzing instrument 201. For instance, the result function is configured to maximize a dynamic range of the analyzing instrument 201. Preferably, at the same time the result function is configured to avoid an overload of in the analyzing instrument.

Fig. 2 further shows an example spectrum 203 of a RF or MW signal, which was measured by the quantum sensor 103. The quantum sensor 103 can be a quantum spectrum analyzer, which is capable of acquiring the spectrum 203 with high accuracy.

The spectrum 203 shown in Fig. 2 comprises a strong interference signal, which could negatively affect an analysis of weaker signal components in the spectrum.

The processing unit 105 can be configured to detect the interference signal and to adjust the filter unit 107 to attenuate or filter out the interference signal. In particular, the processing unit 105 can be configured to control at least one filter coefficient of the adjustable filter unit 107 to adapt its filter function.

The filter function can refer to or be characterized by the transfer function of the filter unit 107. In particular, the filter function defines a filter profile of the filter unit 107. The filter profile can represent a frequency dependent transmission, i.e. a transmission spectrum, of the filter unit 107. If the transmission of the filter unit 107 is low in certain frequency range, the signal component within this range is attenuated by the filter unit 107.

Fig. 2 further shows a representation of the filter profile 205 of the filter unit 107, which is adapted to block the signal in the frequency range of the interference signal in the spectrum 203, and to transmit all other frequencies of the spectrum 203. In this way, the interference signal is efficiently removed from the signal 101.

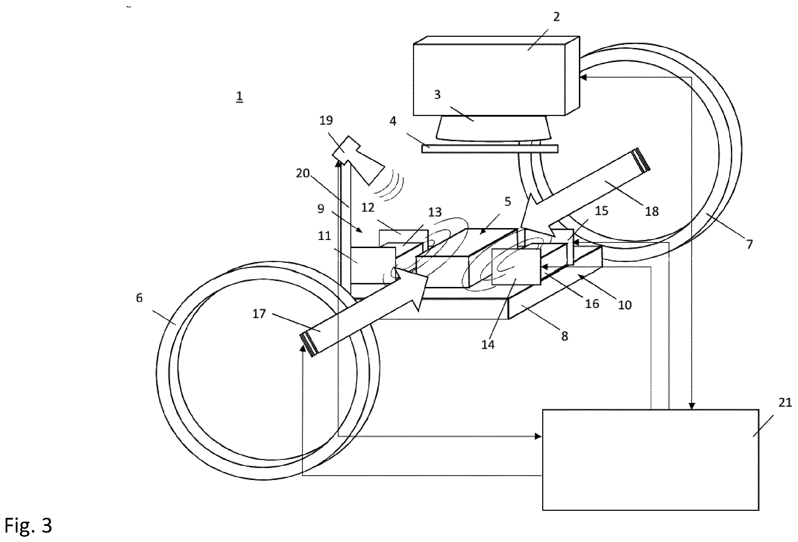

Fig. 3 shows a schematic diagram of the gas based quantum sensor 1 according to an embodiment. The quantum sensor 103 of the system 100 shown in Figs. 1 and/or 2 can corresponds to the quantum sensor 1 shown in Fig. 3.

The quantum sensor 1 comprises a camera 2 which can be equipped with a lens system 3 for capturing fluorescent light that is emitted by a gas provided in a hermetically sealed enclosure 5. The light that is emitted by the gas atoms contained in the gas inside the enclosure 5 may be filtered by a filter 4 that is adjusted to let the fluorescent light pass. The enclosure 5 can be arranged between a pair of permanent magnet rings 6 and 7 as magnetic field source. It is to be noted that any type of magnetic field source, specifically coils, may be used. In case of using coils it is possible to control the strength of the field by its driver. The enclosure 5 is placed on a base plate 8, which in the simplest case may be provided for supporting reasons only. However, according to a preferred embodiment, the base plate 8 may be heated such that the enclosure 5 and, thus, the gas contained in it can be maintained at a desired and preferably constant temperature, which is for example 60°C in case that the gas contains Caesium atoms as the responsive atoms for conducting the measurement. At 60°C, the Caesium atoms are in the gas phase.

The quantum sensor 1 may comprise a source for an electrical field, which is in the illustrated embodiment a pair of capacitors 9, 10 arranged at opposite sides of the enclosure 5. The capacitors 9, 10 each comprise a pair of electrodes 11, 12 and 14, 15 respectively, with a dielectric material 13 and 16 placed between them. The capacitors 9, 10 can generate an electrical field which is static but inhomogeneous in the area of the enclosure 5. Towards the symmetry axis, the strength of the electrical field increases

Preferably, the gas atoms in the enclosure 5 are so called Rydberg atoms that are excited by a plurality of laser beams, indicated with reference numeral 17 and 18 in the drawing. The lasers are operated for example at a wave length of approximately 850 nm, 852 nm and 1470 nm in case of using three lasers as light sources in order to excite the outer electrons of the gas atoms of the active gas portion in the enclosure 5 into the Rydberg state.

The RF or MW signal 101 to be measured can be emitted by an antenna 19, 20, which preferably is a horn antenna so that the radiation can be focused inside the enclosure 5. In order to avoid any relative displacement of the antenna 19 with respect to the enclosure 5, a post is provided on the base plate 8 supporting the antenna 19.

In order to analyze the RF or MW signal 101 and to measure the spectrum of the signal, the camera 2 captures the fluorescent light emitted by the gas atoms, in the preferred embodiment Caesium atoms. Since the electrical field generated by the capacitors 9 and 10 varies with the location inside the enclosure 5, the resonance frequency for the electromagnetic radiation (i.e., the RF or MW signal) depends on the location. Since the camera 2 generates an image that is two-dimensional, the intensity of the fluorescent light is captured with a spatial resolution. Thus, one dimension of the two-dimensional image reflects the frequency information whereas the other dimension shows a gradient of intensity for improving the dynamic range.

The quantum sensor 1 may further comprise a spectrum analysis module configured to calculate the spectrum of the RF or MW signal 101 on the basis of the output of the camera 2. For instance, the camera produces an at least two dimensional image of light emitted by the active atoms and/or passed through the gas.

In an alternative arrangement, instead of the camera 2 a photo sensor 22 including at least one photodiode is can be used, wherein, the frequency of the laser is sweeped together with the strength of the electrical field.

The gas in the enclosure 5 can be a mixture of the atoms of a known type and at least one additional type of atoms or molecules. In particular, the atoms or molecules are Rydberg atoms respectively Rydberg molecules.

The quantum sensor 1 can comprise a controller 21. The controller 21, for instance, controls the camera 2, the laser sources 17 and 18, emission of the radiation to be analyzed and further adjusts the strength of the electrical field by controlling the capacitors 9 and 10. The controller 21 can comprise the spectrum analysis module.

Such a quantum sensor 1 is, for instance, disclosed in document EP 3 809 145 A1.

The quantum sensor 1 as shown in Fig. 3 can be used as a quantum spectrum analyzer in the system of Figs. 1 or 2. Using such a quantum sensor 1 offers many advantages over conventional spectrum analysis devices. For instance, the quantum sensor 1 is able to do a "multichannel" real-time measurement of the RF or MW signal. In particular, the quantum sensor 1 consists of multiple independent atoms for sensing, where each atom senses a different frequency of the input signal. When there is a strong input signal at a particular frequency, the quantum spectrum analyzer becomes saturated at that frequency, but the measurements for other frequencies are unaffected (because they are being carried out by other, independent atoms). In contrast, a conventional real-time spectrum analysis device digitalizes the input signal with an ADC, where the entire output can become invalid when there is a strong input signal at a single frequency component.

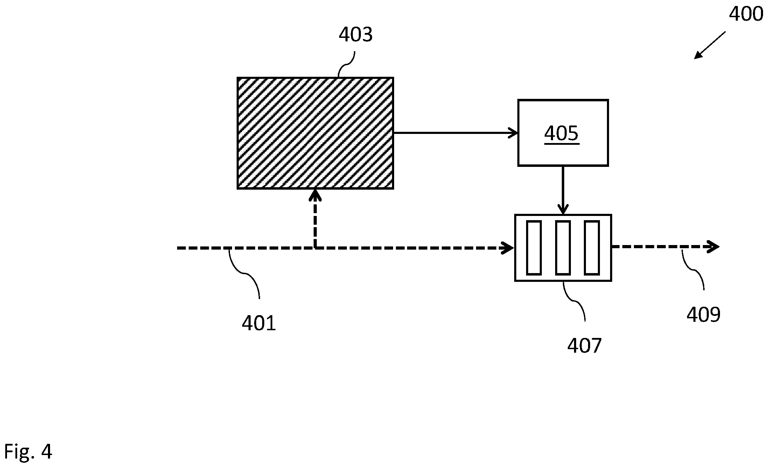

Fig. 4 shows an alternative system 400 for filtering an RF or MW signal 401 according to an embodiment.

The RF or MW signal 401 comprises at least one frequency band. The system 400 comprises at least multi-channel spectrum analysis device 403 which is arranged to receive the RF or MW signal 401, wherein the multi-channel spectrum analysis device 403 is configured to measure a spectrum of the RF or MW signal 401 in a determined frequency range, and a processing unit 405 which is configured to analyze said spectrum to detect if a signal strength of one or more frequency bands of the RF or MW signal 401 within the frequency range exceed a predefined threshold. The system 400 further comprises an adjustable filter unit 407 which is arranged to receive and to filter the RF or MW signal 401, wherein the processing unit 405 is configured to adapt a filter function of the adjustable filter unit 407 based on said analysis of the spectrum.

In particular, the system 400 shown in Fig. 4 corresponds to the system 100 shown in Fig. 1, wherein the at least one quantum sensor 103 is replaced by the at least one multi-channel spectrum analysis device 403, which is capable of performing the same or a similar function as the quantum sensor 103. The remaining components of the system 400, e.g. the processing unit 405 and the filter unit 407, can be configured according to their counterparts 105, 107 in the system 100 shown in Figs. 1 or 2. Thus, also the system 400 in Fig. 4 is capable of generating a filtered RF or MW signal 409 in which strong interference signals are filtered out or attenuated and provide said signal 409 to an analyzing instrument.

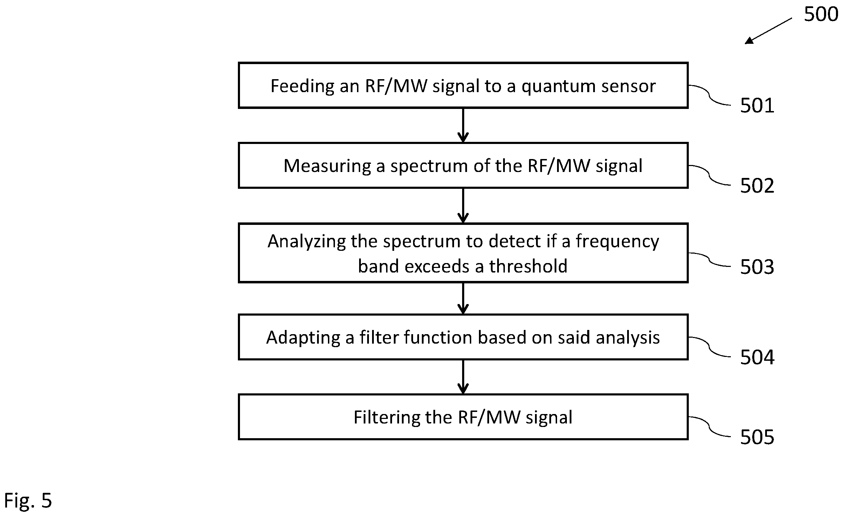

Fig. 5 shows a method 500 for filtering the RF or MW signal 101 according to an embodiment.

The method 500 comprises the steps of:
- feeding 501 the RF or MW signal 101 to the at least one gas based quantum sensor 103;
- measuring 502, with the gas based quantum sensor 103, the spectrum of the RF or MW signal 101 in a determined frequency range;
- analyzing 503 said spectrum to detect if the signal strength of one or more frequency bands of the RF or MW signal 101 in the frequency range exceed a predefined threshold;
- adapting 504 a filter function of the adjustable filter unit 107 based on said analysis of the spectrum; and
- filtering 505 the RF or MW signal 101 with the adjustable filter unit 109.

The step of filtering 505 the RF or MW signal 101 can comprise filtering out or attenuating at least one frequency band of the RF or MW signal that exceeds the predefined threshold.

Thereby, the filter function of the adjustable filter unit 107 can be adapted by controlling at least one filter coefficient of the adjustable filter unit 107.

## Claims

1. A system (100) for filtering a radio frequency, RF, or microwave, MW, signal (101) comprising at least one frequency band, the system comprising:
at least one quantum sensor (103, 1) which is arranged to receive the RF or MW signal (101), wherein the quantum sensor (103, 1) is configured to measure a spectrum (203) of the RF or MW signal (101) in a determined frequency range;
a processing unit (105) which is configured to analyze said spectrum (203) to detect if a signal strength of one or more frequency bands of the RF or MW signal (101) within the frequency range exceed a predefined threshold; and
an adjustable filter unit (107) which is arranged to receive and to filter the RF or MW signal (101);
wherein the processing unit (105) is configured to adapt a filter function of the adjustable filter unit (107) based on the analysis of the spectrum (203),
wherein the at least one quantum sensor (103, 1) comprises a reach-through output being directly connected to the adjustable filter unit (107).

2. The system (100) of claim 1,
wherein the processing unit (105) is configured to adapt the filter function of the adjustable filter unit (107) to filter out or attenuate at least one frequency band of the RF or MW signal (101) that exceeds the predefined threshold.

3. The system (100) of claim 1 or 2,
wherein the processing unit (105) is configured to control at least one filter coefficient of the adjustable filter unit (107) to adapt the filter function of the adjustable filter unit (107).

4. The system (100) of any one of the preceding claims,
wherein the filter unit (107) comprises a plurality of filters forming a filter bank.

5. The system (100) of any one of the preceding claims,
wherein the filter unit (107) is configured to divide the RF or MW signal (101) into more than one separate signals.

6. The system (100) of any one of the preceding claims,
wherein the system (100) comprises at least one analyzing instrument (201) which is arranged to receive the filtered RF or MW signal (109) from the filter unit (107).

7. The system (100) of claim 6,
wherein the at least one analyzing instrument (201) comprises an analog-to-digital converter, ADC, configured to digitalize the filtered RF or MW signal (109).

8. The system (100) of claim 6 or 7,
wherein the processing unit (105) is configured to calculate the threshold based on a result function, wherein the results function is configured to maximize a dynamic range of the at least one analyzing instrument (201) while preventing an overload of the analyzing instrument (201).

9. The system (100) of any one of the preceding claims,
wherein the quantum sensor is a gas based quantum sensor (103, 1) comprising:
an enclosure (5) filled with a gas containing atoms of at least one known type, in particular Rydberg atoms, wherein the enclosure (5) is arranged such that the RF or MW signal (101) acts on the atoms of the gas;
at least one light source configured to emit light capable of exciting the atoms of the gas;
a sensor (2, 22) configured to capture light emitted by and/or passed through the gas; and
an electrical field source (9, 10) and/or a magnetic field source (6, 7) configured to establish a predefined electrical field and/or magnetic field acting on the atoms of the gas, such that the light captured by the sensor (2, 22) reflects a response of the atoms of the gas on the electrical and/or magnetic field, the light from the at least one light source and the RF or MW signal (101).

10. The system (100) of claim 9,
wherein the sensor (2, 22) is configured to capture an at least two dimensional image of the light emitted by and/or passed through the gas;
wherein the gas based quantum sensor (103, 1) comprises a spectrum analysis module configured to calculate the spectrum (203) of the RF or MW signal (101) on the basis of the image.

11. The system (100) of any one of claims 1 to 10,
wherein the adjustable filter unit (107) is arranged to receive the RF or MW signal (101) from a pass-through output of the at least one quantum sensor (103, 1).

12. The system (100) of any one of claims 1 to 10,
wherein the at least one quantum sensor (103, 1) and the adjustable filter unit (107) are arranged to receive respective split portions of the RF or MW signal (101).

13. A method (500) for filtering a radio frequency, RF, or microwave, MW, signal (101) comprising at least one frequency band, the method (500) comprising:
feeding (501) the RF or MW signal (101) to at least one quantum sensor (103, 1);
measuring (502), with the quantum sensor (103, 1), a spectrum (203) of the RF or MW signal (101) in a determined frequency range;
analyzing (503) said spectrum (203) to detect if a signal strength of one or more frequency bands of the RF or MW signal (101) in the frequency range exceed a predefined threshold;
adapting (504) a filter function of an adjustable filter unit (107) based on the analysis (503) of the spectrum (203); and
filtering (505) the RF or MW signal (101) with the adjustable filter unit (107),
wherein the at least one quantum sensor (103, 1) comprises a reach-through output being directly connected to the adjustable filter unit (107).

## Patentansprüche

1. System (100) zum Filtern eines Hochfrequenz- oder Mikrowellen-Signals, HF- oder MW-Signal (101), umfassend mindestens ein Frequenzband, das System umfassend:
mindestens einen Quantensensor (103, 1), der angeordnet ist, um das HF- oder MW-Signal (101) zu empfangen, wobei der Quantensensor (103, 1) konfiguriert ist, um ein Spektrum (203) des HF- oder MW-Signals (101) in einem bestimmten Frequenzbereich zu messen;
eine Verarbeitungseinheit (105), die konfiguriert ist, um das Spektrum (203) zu analysieren, um zu erkennen, ob eine Signalstärke eines oder mehrerer Frequenzbänder des HF- oder MW-Signals (101) innerhalb des Frequenzbereichs einen vordefinierten Schwellenwert überschreitet; und
eine einstellbare Filtereinheit (107), die angeordnet ist, um das HF- oder MW-Signal (101) zu empfangen oder zu filtern;
wobei die Verarbeitungseinheit (105) konfiguriert ist, um eine Filterfunktion der einstellbaren Filtereinheit (107) basierend auf der Analyse des Spektrums (203) anzupassen,
wobei der mindestens eine Quantensensor (103, 1) einen Durchgriffsausgang umfasst, der direkt mit der einstellbaren Filtereinheit (107) verbunden ist.

2. System (100) nach Anspruch 1,
wobei die Verarbeitungseinheit (105) konfiguriert ist, um die Filterfunktion der einstellbaren Filtereinheit (107) anzupassen, um mindestens ein Frequenzband des HF- oder MW-Signals (101), das den vordefinierten Schwellenwert überschreitet, herauszufiltern oder zu dämpfen.

3. System (100) nach Anspruch 1 oder 2,
wobei die Verarbeitungseinheit (105) konfiguriert ist, um mindestens einen Filterkoeffizienten der einstellbaren Filtereinheit (107) zu steuern, um die Filterfunktion der einstellbaren Filtereinheit (107) anzupassen.

4. System (100) nach einem der vorstehenden Ansprüche,
wobei die Filtereinheit (107) eine Vielzahl von Filtern umfasst, die eine Filterbank ausbilden.

5. System (100) nach einem der vorstehenden Ansprüche,
wobei die Filtereinheit (107) konfiguriert ist, um das HF- oder MW-Signal (101) in mehr als ein separates Signal aufzuteilen.

6. System (100) nach einem der vorstehenden Ansprüche,
wobei das System (100) mindestens ein Analyseinstrument (201) umfasst, das angeordnet ist, um das gefilterte HF- oder MW-Signal (109) von der Filtereinheit (107) zu empfangen.

7. System (100) nach Anspruch 6,
wobei das mindestens eine Analyseinstrument (201) einen Analog-DigitalWandler, ADC, umfasst, der konfiguriert ist, um das gefilterte HF- oder MW-Signal (109) zu digitalisieren.

8. System (100) nach Anspruch 6 oder 7,
wobei die Verarbeitungseinheit (105) konfiguriert ist, um den Schwellenwert basierend auf einer Ergebnisfunktion zu berechnen, wobei die Ergebnisfunktion konfiguriert ist, um einen Dynamikbereich des mindestens einen Analyseinstruments (201) zu maximieren und gleichzeitig eine Überlastung des Analyseinstruments (201) zu verhindern.

9. System (100) nach einem der vorstehenden Ansprüche,
wobei der Quantensensor ein gasbasierter Quantensensor (103, 1) ist, umfassend:
ein Gehäuse (5), das mit einem Gas gefüllt ist, das Atome mindestens einer bekannten Art enthält, insbesondere Rydberg-Atome, wobei das Gehäuse (5) derart angeordnet ist, dass das HF- oder MW-Signal (101) auf die Atome des Gases einwirkt;
mindestens eine Lichtquelle, die konfiguriert ist, um Licht zu emittieren, das in der Lage ist, die Atome des Gases zu stimulieren;
einen Sensor (2, 22), der konfiguriert ist, um Licht zu erfassen, das durch das Gas emittiert wird und/oder durch das Gas passiert; und
eine elektrische Feldquelle (9, 10) und/oder eine magnetische Feldquelle (6, 7), die konfiguriert ist, um ein vordefiniertes elektrisches Feld und/oder magnetisches Feld aufzubauen, das derart auf die Atome des Gases einwirkt, dass das Licht, das durch den Sensor (2, 22) erfasst wird, eine Reaktion der Atome des Gases auf das elektrische und/oder magnetische Feld, das Licht von der mindestens einen Lichtquelle und das HF- oder MW-Signal (101) widerspiegelt.

10. System (100) nach Anspruch 9,
wobei der Sensor (2, 22) konfiguriert ist, um ein mindestens zweidimensionales Bild des Lichts zu erfassen, das durch das Gas emittiert wird und/oder durch das Gas passiert;
wobei der gasbasierte Quantensensor (103, 1) ein Spektrumanalysemodul umfasst, das konfiguriert ist, um das Spektrum (203) des HF- oder MW-Signals (101) auf der Grundlage des Bilds zu berechnen.

11. System (100) nach einem der Ansprüche 1 bis 10,
wobei die einstellbare Filtereinheit (107) angeordnet ist, um das HF- oder MW-Signal (101) von einem Durchgangsausgang des mindestens einen Quantensensors (103, 1) zu empfangen.

12. System (1) nach einem der Ansprüche 1 bis 10,
wobei der mindestens eine Quantensensor (103, 1) und die einstellbare Filtereinheit (107) angeordnet sind, um jeweilige aufgeteilte Abschnitte des HF- oder MW-Signals (101) zu empfangen.

13. Verfahren (500) zum Filtern eines Hochfrequenz- oder Mikrowellen-Signals, HF- oder MW-Signal (101), umfassend mindestens ein Frequenzband, das Verfahren (500) umfassend:
Zuführen (501) des HF- oder MW-Signals (101) zu mindestens einem Quantensensor (103, 1);
Messen (502), mit dem Quantensensor (103, 1), eines Spektrums (203) des HF- oder MW-Signals (101) in einem bestimmten Frequenzbereich;
Analysieren (503) des Spektrums (203), um zu erkennen, ob eine Signalstärke eines oder mehrerer Frequenzbänder des HF- oder MW-Signals (101) in dem Frequenzbereich einen vordefinierten Schwellenwert überschreitet;
Anpassen (504) einer Filterfunktion einer einstellbaren Filtereinheit (107) basierend auf der Analyse (503) des Spektrums (203); und
Filtern (505) des HF- oder MW-Signals (101) mit der einstellbaren Filtereinheit (107),
wobei der mindestens eine Quantensensor (103, 1) einen Durchgriffsausgang umfasst, der direkt mit der einstellbaren Filtereinheit (107) verbunden ist.

## Revendications

1. Système (100) permettant de filtrer un signal radiofréquence, RF, ou hyperfréquences, MW, (101) comprenant au moins une bande de fréquences, le système comprenant :
au moins un capteur quantique (103, 1) qui est conçu pour recevoir le signal RF ou MW (101), dans lequel le capteur quantique (103, 1) est configuré pour mesurer un spectre (203) du signal RF ou MW (101) dans une gamme de fréquences déterminée ;
une unité de traitement (105) qui est configurée pour analyser ledit spectre (203) afin de détecter si une intensité de signal d'une ou plusieurs bandes de fréquences du signal RF ou MW (101) dans la gamme de fréquences dépasse un seuil prédéfini ; et
une unité de filtrage réglable (107) qui est conçue pour recevoir et filtrer le signal RF ou MW (101) ;
dans lequel l'unité de traitement (105) est configurée pour adapter une fonction de filtrage de l'unité de filtrage réglable (107) sur la base de l'analyse du spectre (203),
dans lequel l'au moins un capteur quantique (103, 1) comprend une sortie traversante qui est directement connectée à l'unité de filtrage réglable (107).

2. Système (100) selon la revendication 1,
dans lequel l'unité de traitement (105) est configurée pour adapter la fonction de filtrage de l'unité de filtrage réglable (107) afin de filtrer ou d'atténuer au moins une bande de fréquences du signal RF ou MW (101) qui dépasse le seuil prédéfini.

3. Système (100) selon la revendication 1 ou 2,
dans lequel l'unité de traitement (105) est configurée pour commander au moins un coefficient de filtrage de l'unité de filtrage réglable (107) afin d'adapter la fonction de filtrage de l'unité de filtrage réglable (107).

4. Système (100) selon l'une quelconque des revendications précédentes,
dans lequel l'unité de filtrage (107) comprend une pluralité de filtres formant une banque de filtres.

5. Système (100) selon l'une quelconque des revendications précédentes,
dans lequel l'unité de filtrage (107) est configurée pour diviser le signal RF ou MW (101) en plusieurs signaux distincts.

6. Système (100) selon l'une quelconque des revendications précédentes,
dans lequel le système (100) comprend au moins un instrument d'analyse (201) qui est conçu pour recevoir le signal RF ou MW filtré (109) à partir de l'unité de filtrage (107).

7. Système (100) selon la revendication 6,
dans lequel l'au moins un instrument d'analyse (201) comprend un convertisseur analogique-numérique, ADC, configuré pour numériser le signal RF ou MW filtré (109).

8. Système (100) selon la revendication 6 ou 7,
dans lequel l'unité de traitement (105) est configurée pour calculer le seuil sur la base d'une fonction de résultat, dans lequel la fonction de résultat est configurée pour maximiser une plage dynamique de l'au moins un instrument d'analyse (201) tout en empêchant une surcharge de l'instrument d'analyse (201).

9. Système (100) selon l'une quelconque des revendications précédentes,
dans lequel le capteur quantique est un capteur quantique à base de gaz (103, 1) comprenant :
une enceinte (5) remplie d'un gaz contenant des atomes d'au moins un type connu, en particulier des atomes de Rydberg, dans lequel l'enceinte (5) est disposée de manière à ce que le signal RF ou MW (101) agisse sur les atomes du gaz ;
au moins une source de lumière configurée pour émettre une lumière capable d'exciter les atomes du gaz ;
un capteur (2, 22) configuré pour capter la lumière émise par et/ou traversant le gaz ; et
une source de champ électrique (9, 10) et/ou une source de champ magnétique (6, 7) configurée pour établir un champ électrique et/ou un champ magnétique prédéfini agissant sur les atomes du gaz, de sorte que la lumière capturée par le capteur (2, 22) reflète une réponse des atomes du gaz au champ électrique et/ou magnétique, à la lumière provenant de l'au moins une source de lumière et au signal RF ou MW (101).

10. Système (100) selon la revendication 9,
le capteur (2, 22) est configuré pour capturer une image au moins bidimensionnelle de la lumière émise par et/ou traversant le gaz ;
dans lequel le capteur quantique à base de gaz (103, 1) comprend un module d'analyse spectrale configuré pour calculer le spectre (203) du signal RF ou MW (101) sur la base de l'image.

11. Système (100) selon l'une quelconque des revendications 1 à 10,
dans lequel l'unité de filtrage réglable (107) est conçue pour recevoir le signal RF ou MW (101) à partir d'une sortie traversante de l'au moins un capteur quantique (103, 1).

12. Système (100) selon l'une quelconque des revendications 1 à 10,
dans lequel l'au moins un capteur quantique (103, 1) et l'unité de filtrage réglable (107) sont disposés de manière à recevoir des parties divisées respectives du signal RF ou MW (101).

13. Procédé (500) permettant de filtrer un signal radiofréquence, RF, ou hyperfréquences, MW, (101) comprenant au moins une bande de fréquences, le procédé (500) comprenant :
l'envoi (501) du signal RF ou MW (101) à au moins un capteur quantique (103, 1) ;
la mesure (502), avec le capteur quantique (103, 1), d'un spectre (203) du signal RF ou MW (101) dans une gamme de fréquences déterminée ;
l'analyse (503) dudit spectre (203) pour détecter si une intensité de signal d'une ou plusieurs bandes de fréquences du signal RF ou MW (101) dans la gamme de fréquences dépasse un seuil prédéfini ;
l'adaptation (504) d'une fonction de filtrage d'une unité de filtrage réglable (107) sur la base de l'analyse (503) du spectre (203) ; et
le filtrage (505) du signal RF ou MW (101) à l'aide de l'unité de filtrage réglable (107),
dans lequel l'au moins un capteur quantique (103, 1) comprend une sortie traversante qui est directement connectée à l'unité de filtrage réglable (107).
